(19) Europäisches Patentamt

European Patent Office

Office européen des brevets

(11) **EP 0 454 555 B1**

(12) **FASCICULE DE BREVET EUROPEEN**

(45) Date de publication et mention
de la délivrance du brevet:
**30.08.2000 Bulletin 2000/35**

(51) Int. Cl.⁷: **H01L 21/00**, B65G 51/02,
B08B 5/02, B08B 17/02

(21) Numéro de dépôt: **91401057.4**

(22) Date de dépôt: **22.04.1991**

(54) **Rampe soufflante**

Blasrampe

Blowing ramp

(84) Etats contractants désignés:
**CH DE GB IT LI NL**

(30) Priorité: **24.04.1990 FR 9005210**

(43) Date de publication de la demande:
**30.10.1991 Bulletin 1991/44**

(73) Titulaire:
**COMMISSARIAT A L'ENERGIE ATOMIQUE
75015 Paris (FR)**

(72) Inventeurs:
• **Cruz, Didier**
  **F-38100 Grenoble (FR)**
• **Daval, Jacques**
  **F-38240 Meylan (FR)**
• **Lazzari, Jean-Pierre**
  **F-38700 Corenc (FR)**
• **Torrecillas, François**
  **F-38720 Saint Pancrasse (FR)**

(74) Mandataire:
**Des Termes, Monique et al
Société Brevatome
3, rue du Docteur Lancereaux
75008 Paris (FR)**

(56) Documents cités:
**EP-A- 0 224 034          EP-A- 0 346 224
WO-A-89/12907           US-A- 3 438 668
US-A- 4 037 830          US-A- 4 236 851**

• **IBM TECHNICAL DISCLOSURE BULLETIN, vol.
22, no. 5, octobre 1979, pages 1864-1865, New
York, US; W.B. BALDER et al.: "Diverted flow
bernoulli pick-up device"**
• **IDEM**
• **MUSITS B ET AL: "Wafer handling system", IBM
TECHNICAL DISCLOSURE BULLETIN, NEW
YORK, US, Mars 1975, Vol. 17, no. 10, page 2904**

## Description

### DOMAINE DE L'INVENTION

L'invention concerne le stockage et plus particulièrement, le transport de pièces dont une surface doit être maintenue dans un environnement ultrapropre. Elle s'applique particulièrement à la protection contre la pollution ou la contamination particulaire ambiante de tranches de silicium pendant leur transport.

### ART ANTERIEUR

En effet, lors de la fabrication de circuits intégrés, les tranches de silicium supportant ces circuits intégrés sont stockées dans des stations de chargement et de déchargement. On les y achemine par des moyens de transport adaptés, tels que des coussins d'air, des transporteurs à courroie, des préhenseurs à vide. Ces déplacements s'effectuent entre différentes stations de traitement qui peuvent être un réacteur, un four ou un isolateur. Les tranches peuvent être ensuite stockées de nouveau. Les différentes stations de traitement sont soumises à un environnement ultrapropre et non polluant pour les tranches de silicium. Par contre, une contamination par poussière est toujours possible lors d'un transport, si celui-ci ne bénéficie pas de précautions d'environnement particulières.

Pour résoudre le problème de la contamination lors de l'acheminement des tranches de silicium vers les stations, des moyens de transport sont habituellement placés dans un tube rigide, adapté et soumis à une circulation d'air non polluant. Cette solution présente l'inconvénient majeur de nécessiter une mécanique adaptée une fois pour toutes à l'équipement et difficilement applicable à tous les cas de transport rencontrés, lors des cheminements des tranches de silicium.

D'autre part, on connaît par la demande de brevet français, publiée sous le numéro 2 632 617, un couloir adaptable pour le transport de pièces dans un environnement ultrapropre. Ce couloir comprend un premier type d'éléments unitaires horizontaux constitués de conduits unitaires pourvus de buses et d'un système d'accrochage. Deux jupes latérales en matière souple et imperméables à l'air sont constituées par un second type d'éléments unitaires verticaux. Les conduits horizontaux étant reliés à une source d'air sous pression, les buses projettent cet air à l'intérieur du couloir constitué par les conduits unitaires horizontaux et les éléments latéraux formant la jupe. Ces éléments sont assemblés les uns aux autres de manière à s'adapter à la géométrie du parcours à protéger. Ce couloir a pour application la protection contre la pollution de tranches de silicium pendant leur transport. Ce type de couloir peut être efficace en maintenant un environnement ultrapropre, mais en mettant en jeu des débits d'air importants.

On connaît également par le brevet américain US-A-4236851 un dispositif et un procédé de manipulation d'objets plats, tels que des tranches de silicium. Dans ce dispositif, ces tranches de silicium sont transportées par suspension du fait d'une différence de pression entre les surfaces inférieure et supérieure de chaque tranche. En effet, une piste supérieure est placée au-dessus des tranches et possède des trous de distribution d'air inclinés de manière à faire avancer les tranches dans la direction souhaitée. On constate que les tranches de silicium sont placées, par leur surface supérieure, très près de la piste de distribution d'air. Etant donné la différence de pression qui existe de part et d'autre des tranches de silicium, on peut affirmer que le flux arrivant au-dessus de ces dernières produit des turbulences qui favorisent, avec la différence de pression, le transit de poussières contaminantes autour des tranches. De plus, l'air arrivant sur le dessus des tranches de silicium n'est pas spécialement prévu pour entretenir une atmosphère ultrapropre sur la surface supérieure.

IBM TECHNICAL DISCLOSURE BULLETIN, volume 22, n° 5, d'Octobre 1979, pages 1 864 et 1 865, décrit un système de préhension de tranches de semi-conducteur. Ce dispositif permet d'éviter l'introduction de particules contaminées sur les tranches de semi-conducteur. On y utilise un premier flux d'air circulaire dispensé par une rainure circulaire et inclinée. Le flux d'air ainsi distribué se répartit vers la périphérie de la surfce supérieure de la tranche de silicium et assure la rétention de cette dernière par effet Bernouilli. Comme pour le document précédent, et compte tenu des différences de pression créées par le vide, le flux d'air dispensé ne peut pas être laminaire.

US-A-3438668 et WO-A-89/12907 décrivent des dispositifs similaires.

US-A-4037830 décrit un dispositif de préhension mettant en oeuvre un flux laminaire. Par ailleurs, IBM TECHNICAL DISCLOSURE BULLETIN, volume 17, n° 10, de mars 1975, page 2904, décrit un couloir pour tranches semi-conductrices utilisant un flux laminaire.

Le but de l'invention est de fournir des moyens de protection des tranches de silicium pendant leur transport en utilisant la technique de soufflage d'air sous pression, mais en évitant l'inconvénient sus-mentionné.

### RESUME DE L'INVENTION

A cet effet, l'objet principal de l'invention est une rampe soufflante pour la protection de surfaces d'objets contre la contamination particulaire ambiante par confinement dans une atmosphère d'air ultrapropre au moyen d'éléments soufflants distribuant l'air ultrapropre par des orifices de distribution d'air débouchant par une surface soufflante dans un espace où les objets à confiner doivent être placés.

Selon l'invention, elle comprend plusieurs éléments soufflants assemblés les uns aux autres et composés chacun de :

- une plaque ayant une surface soufflante comprenant au moins un orifice central ou médian et ayant une forme complémentaire à celle d'au moins la périphérie des surfaces à protéger ;
- une canalisation fixée à la plaque débouchant dans l'orifice et pouvant être reliée à une source d'air ultrapropre, certains éléments soufflants étant allongés, leurs orifices étant constitués d'une rainure médiane longitudinale.

D'autres éléments soufflants sont ronds et ont un unique orifice central. Ils constituent ainsi une rampe soufflante adaptable au trajet parcouru par les objets portant la surface à protéger, les différents éléments soufflants étant mis bout à bout, la rampe étant ainsi adaptée pour confiner les surfaces à protéger dans l'air ultrapropre en plaçant les surfaces à protéger à une distance (d) relativement courte de la surface soufflante, l'air ultrapropre ayant un débit ayant une valeur comprise entre un débit minimal qui est le débit pour lequel l'air peut encore balayer toute les surfaces à protéger de l'objet et sortir en périphérie de celles-ci, et un débit maximal qui est le débit juste au-dessus duquel apparaît un régime turbulent de l'air ultrapropre, l'écoulement de l'air ultrapropre dans le volume formé par les surfaces à protéger et la surface soufflante placées parallèlement en regard l'une de l'autre étant ainsi laminaire, au moins à la périphérie des surfaces à protéger.

De préférence, la rampe soufflante comprend à chaque extrémité des éléments d'extrémité comportant une portion transversale de canalisation formant ainsi un rideau d'air transversal.

Chaque canalisation peut être complétée d'une chicane placée en regard de conduits d'alimentation débouchant dans les canalisations, améliorant ainsi la répartition de l'air ultrapropre dans toute la canalisation.

LISTE DES FIGURES

L'invention et ses différentes caractéristiques techniques seront mieux comprises à la lecture de la description suivante. Cette dernière est accompagnée de plusieurs figures représentant respectivement :

- figure 1, un élément de ligne droite d'un moyen de transport de tranches de silicium auxquelles s'applique l'invention ;
- figure 2, un dispositif de changement de direction des moyens de transport des tranches de silicium auxquelles s'applique l'invention ;
- figure 3, un élément longitudinal utilisé dans la rampe soufflante selon l'invention ;
- figure 4, une coupe transversale de l'élément longitudinal représenté par la figure 3 ;
- figure 5, un élément rond utilisé dans la rampe soufflante selon l'invention ;
- figure 6, un mode de réalisation d'un élément d'extrémité de la rampe selon l'invention ;
- figure 7, un exemple d'assemblage de deux éléments longitudinaux de la rampe selon l'invention ;
- figure 8, en vue de dessus, une rampe selon l'invention avec un changement de direction ;
- figures 9A et 9B, une variante de réalisation d'un élément rond utilisé dans la rampe soufflante selon l'invention.

DESCRIPTION DETAILLEE D'UN MODE DE REALISATION

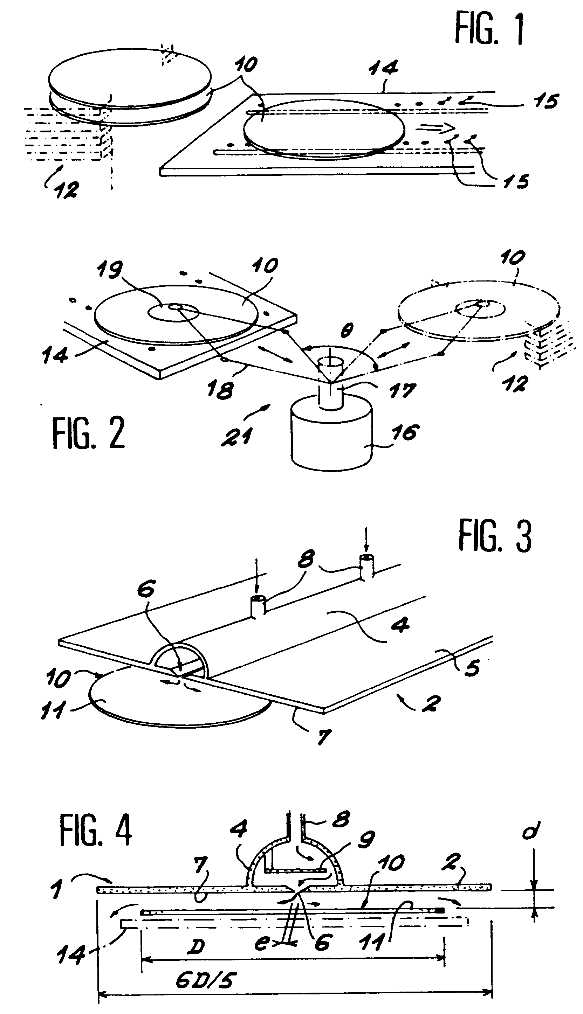

Le moyen de transport d'objets plats, tels que des tranches de silicium, représenté sur la figure 1, est une piste 14 munie de conduits de jets d'air 15 débouchant obliquement dans le sens longitudinal, de manière à faire avancer la tranche de silicium 10. Cette piste 14 est positionnée à la sortie d'une cassette 12 dans laquelle sont rangées plusieurs tranches de silicium 10.

D'autres moyens de transport de ces tranches de silicium 10 existent. En effet, il est possible d'utiliser des transporteurs constitués de deux courroies horizontales et parallèles se translatant horizontalement dans le même sens.

Ces deux types de moyens de transport permettent de faire parcourir aux tranches de silicium des déplacements en ligne droite. Or, dans la plupart des cas d'utilisation de tels transporteurs de tranches de silicium, il s'avère nécessaire de procéder à des changements de direction au cours du transport de ces tranches de silicium.

La figure 2 représente un des dispositifs de changement de direction. Il consiste à placer à proximité d'une piste 14 un préhenseur par succion 21. Ce dernier est constitué d'un bloc de base 16, fixe par rapport à la piste 14 et supportant un arbre tournant vertical 17. Sur ce dernier est monté un système articulé 18 du type pantographe, dont un premier sommet est fixé à l'arbre 17 et dont le deuxième sommet est équipé d'un dispositif à succion. Le déploiement complet du pantographe 18 permet au dispositif à succion 19 de venir au-dessus de la piste 14 pour prendre une tranche de silicium 10. Le repliement du pantographe 18 permet de ramener la tranche de silicium au-dessus du bloc de base 16. On effectue alors une rotation de l'arbre tournant 17, d'un angle θ correspondant à l'angle formé par la direction de la piste amont 14 et la piste aval, qui est symbolisée sur la figure 2 par une cassette de rangement 12. Le pantographe 18 est ensuite redéployé pour placer la tranche de silicium 10 dans la cassette 12.

La rampe soufflante et les différents éléments qui la constituent sont décrits simultanément dans le reste de la présente description.

L'élément représenté sur la figure 3 est un élément soufflant longitudinal, utilisé pour constituer une rampe soufflante. Il est constitué d'une plaque plane 2 constituant un plafond soufflant. Elle possède des orifices 6 débouchant sur sa surface inférieure 7, qui est donc une surface soufflante. Une canalisation 4 est fixée sur la surface supérieure 5 de la plaque 2, en regard des orifices 6. La canalisation 4, représentée sur la figure 3, a une forme semi-cylindrique. Ceci ne constitue qu'un exemple de réalisation, le résultat nécessaire à l'efficacité du procédé étant que cette canalisation 4 alimente en air les orifices centraux 6. L'alimentation de cette canalisation 4 en air ultrapropre peut être obtenue au moyen de conduits 8 débouchant dans cette canalisation 4. Les orifices 6 sont généralement constitués d'une unique fente médiane longitudinale.

Comme le montre cette figure 3, une tranche de silicium 10 est placée juste en-dessous de l'élément soufflant.

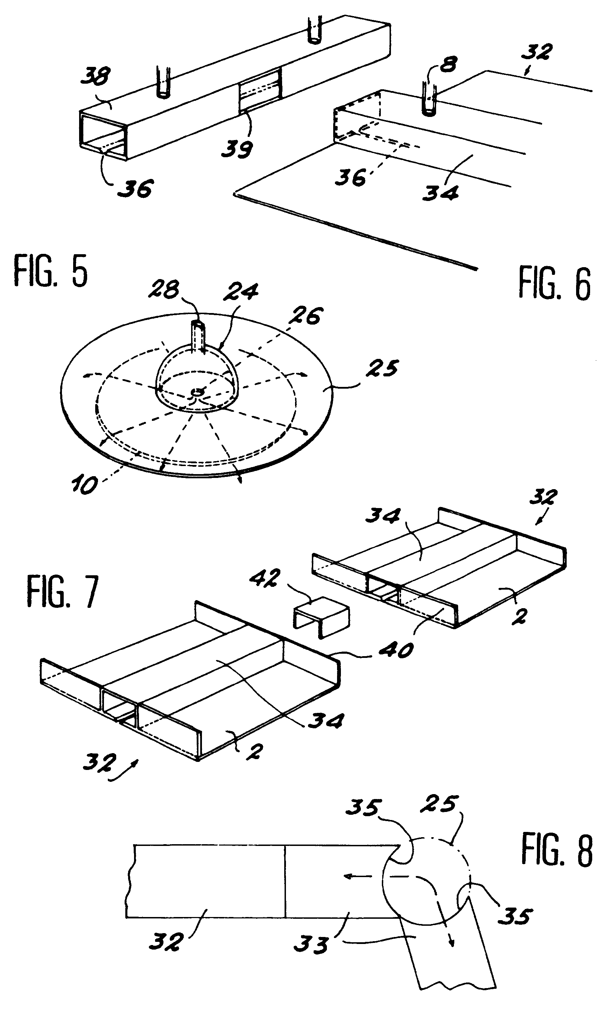

La figure 4 montre de manière plus précise la position de la tranche de silicium 10 par rapport à l'élément longitudinal, repéré 1 sur cette figure. En fait, la plaque de silicium 10 est placée à une distance d qui est de l'ordre du millimètre. Plus exactement, dans le cas de l'application à des tranches de silicium, cette distance est généralement comprise entre 0,5 et 3 mm. On peut comprendre que l'air ultrapropre débouchant de la canalisation 4 par les orifices 6 rencontre aussitôt la surface à protéger de la tranche de silicium 10. De manière non limitative, mais préférentielle, celle-ci est placée symétriquement par rapport aux orifices 6, de sorte que l'air ultrapropre débouchant des orifices 6 de la surface soufflante 7 se répartit de façon égale des deux côtés du volume formé par la surface soufflante 7 et la surface supérieure à protéger 11 de la tranche de silicium 10.

Chaque canalisation 4 peut être complétée à l'intérieur d'une chicane, repérée 9 sur la figure 4. Celle-ci est placée en regard des orifices d'alimentation 8 débouchant dans la partie supérieure de la canalisation 4. Cette chicane 9 est destinée à allonger le parcours de l'air ultrapropre dans la canalisation 4 pour améliorer la répartition de ce dernier dans tout le volume de la canalisation 4. Ceci a pour effet d'uniformiser le débit d'air dans la fente longitudinale 6.

En vue d'obtenir un écoulement laminaire dans ce volume, c'est-à-dire un écoulement régulier sans turbulences et sans courant contraire de l'air, les orifices 6 ont une forme particulière.

Comme le représente la figure 4, les orifices 6 peuvent être constitués d'une fente longitudinale ayant de préférence une forme en V à l'intrieur de la canalisation 4. L'écartement final e de la fente longitudinale est de préférence compris entre 0,3 et 2 mm.

Il faut préciser que la distance d séparant la tranche de silicium 10 de la surface soufflante 7 et l'écartement e de la fente longitudinale formée par les orifices 6 conditionnent, avec le diamètre D de la tranche de silicium 10, le débit Q de l'air ultrapropre. En effet, celui-ci devra prendre une valeur comprise entre un débit minimal et un débit maximal. Le débit minimal est un débit pour lequel l'air peut encore balayer toute la surface 11 de la tranche de silicium 10 et sortir en périphérie de celle-ci. Le débit maximal est celui juste en-dessous duquel apparaît un régime turbulent de l'air ultrapropre.

La plaque 2 est également dimensionnée en fonction du diamètre D de la tranche de silicium 10. Elle est obligatoirement plus large que le diamètre D de la tranche de silicium 10, cette largeur étant de préférence égale à D x 6/5.

Pour des tranches de silicium de diamètre D égal à 150 mm, un écartement e de la fente longitudinale égal à 0,5 mm, une distance d de la tranche de silicium 10 à la plaque 2 égale à 3 mm, la contamination des tranches transportées sous ces éléments est minimale pour un débit de 2 à 3 $m^3$/h.m de rampe soufflante ainsi constituée. Il est donc préférable dans ce cas, d'avoir un débit de l'ordre de 5 $m^3$/h.

A l'aide des conditions de fonctionnement énoncées dans le paragraphe précédent, un calcul faisant intervenir le nombre de REYNOLDS R et la viscosité cinématique de l'air $\nu$, permet de vérifier l'état laminaire de l'écoulement de l'air entre les deux surfaces parallèles.

La vitesse moyenne $V_m$ débitée est égale à $V_m = Q/S$, Q étant le débit intercepté par une tranche de silicium subissant un débit de 5 $m^3$/h.m de galerie. Le débit intercepté par une tranche de silicium est donc égal à $1.Q \times D/L$, D étant le diamètre de la tranche de silicium et L la longueur parcourue ; en conséquence, le débit intercepté par une tranche de diamètre 6" (150 mm) est égal à 5 x 0,15 : 1 = 0,75 $m^3$/h.

Le volume d'air sortant d'un côté d'une tranche de silicium est donc égal à 0,375 $m^3$/h, à travers une section de sortie égale à D x d, c'est-à-dire 0,45 x $10^{-3}$ $m^2$.

La vitesse débitante $V_m$ est égale à 0,375/3 600 x 1/0,45.$10^{-3}$, c'est-à-dire environ 0,23 m/s.

Le nombre de REYNOLDS R est donc égal à $V_m$ x e/$\nu$ égal à 23 x 3.$10^{-1}$/15.$10^{-2}$, c'est-à-dire environ 50.

Pour un écoulement entre deux plans parallèles, il est admis que lorsque le nombre de REYNOLDS R est inférieur à 1400, le régime est parfaitement laminaire. C'est donc le cas de l'exemple cite précédemment.

La figure 5 représente un élément soufflant circulaire. Sa structure et son fonctionnement sont analogues à ceux d'un élément soufflant longitudinal. Les différences fondamentales avec l'élément longitudinal sont que la canalisation se réduit à une simple forme hémisphérique 24. Elle est appliquée à une plaque circulaire 25 au-dessus d'un orifice central 26. Elle est alimentée par un conduit 28 branché à une source d'air ultrapropre.

L'écoulement de l'air à travers l'orifice central 26 se fait de manière analogue à l'écoulement obtenu avec un élément soufflant longitudinal, c'est-à-dire que cet écoulement est symétrique par rapport au centre de la plaque circulaire 25 et reste laminaire.

En référence à la figure 6, il est possible d'envisager différentes constructions des éléments soufflants longitudinaux. Cette figure montre une canalisation 34 de forme rectangulaire. Celle-ci est toujours alimentée par des conduits 8 reliés à une source d'air ultrapropre sous pression.

L'élément longitudinal 32 peut, dans le cas où il constitue l'extrémité d'une rampe soufflante, être équipé d'un élément d'extrémité 38 constitué d'une portion transversale de canalisation reliée à la canalisation 34 par une ouverture latérale 39 placée au milieu de la canalisation 38. Cette dernière possède de manière analogue à la canalisation 34 de l'élément longitudinal 32, une fente 36 analogue à la fente décrite sur les figures 3 et 4. De ce fait, cette canalisation étant également alimentée en air ultrapropre, un rideau d'air transversal constitue une protection supplémentaire des tranches de silicium vis-à-vis de la contamination.

Dans l'utilisation la plus avantageuse de la rampe soufflante, celle-ci est constituée pour les portions droites d'éléments longitudinaux 32 et pour les changements de direction d'éléments soufflants ronds, tels que décrits sur la figure 5.

En référence à la figure 7, les différents éléments soufflants longitudinaux 32 peuvent être assemblés grâce à des flancs de serrage 40. Ces derniers sont placés transversalement et verticalement aux plaques 2, à chaque extrémité de celles-ci. Ces flancs peuvent le cas échéant obturer les canalisations 34. Les éléments longitudinaux 32 sont assemblés par rapprochement en plaçant l'un contre l'autre les flancs transversaux 40 placés aux extrémités respectives des éléments longitudinaux et en les maintenant ainsi collés par serrage et collage.

La réalisation décrite par la figure n'est qu'un exemple. En effet, ils peuvent être mis bout à bout et maintenus grâce à une pièce d'adaptation 42 complémentaire, constituant une portion de conduite. Cette pièce intermédiaire 42 s'insère dans les extrémités respectives des canalisations 34 de deux éléments longitudinaux 32.

La figure 8 montre, en vue de dessus, une rampe soufflante utilisant des premiers éléments soufflants longitudinaux 32 et un élément soufflant circulaire 25 pour effectuer un changement de direction entre deux portions de ligne droite. D'autres éléments longitudinaux 33 sont utilisés pour effectuer le joint entre les éléments soufflants longitudinaux 32 et l'élément soufflant rond 25. Ces deuxièmes éléments soufflants longitudinaux 33 possèdent une extrémité en découpe circulaire, concave 35, complémentaire avec la forme extérieure de l'élément soufflant rond 25.

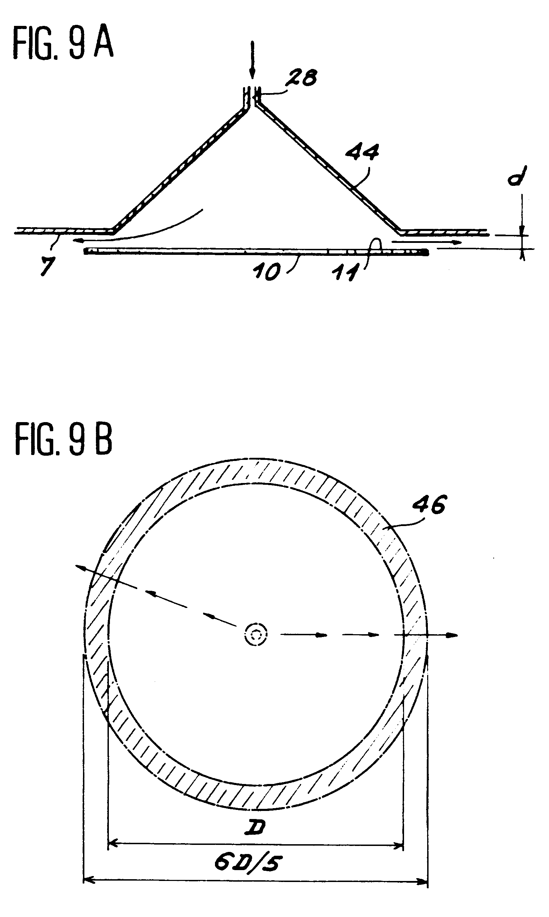

Comme le montrent les figures 9A et 9B, il est possible d'envisager une variante de réalisation de l'élément soufflant rond. Il est en effet possible que la forme de la surface soufflante 7 de l'élément soufflant ne soit complémentaire que sur une partie de la surface 11 à protéger. Le concept de l'invention résidant dans le fait de créer un écoulement laminaire de l'air ultra-propre sur la surface à protéger 11, de manière à ce qu'une entrée éventuelle de particules polluantes ne puisse se produire sur le côte de la surface à protéger 11, on peut limiter cet écoulement laminaire à la périphérie de cette surface à protéger 11. En conséquence, comme le montre la figure 9A, la surface soufflante 7 n'est parallèle à la surface à protéger 11 que sur sa périphérie. Le reste de la surface soufflante peut être constitué d'un cône 44 joignant directement le conduit 28 à la surface soufflante 7. L'air ultra-propre se répartit symétriquement dans le volume pyramidal ainsi délimité. L'écoulement laminaire a lieu dans la partie périphérique, c'est-à-dire lorsque l'air ultra-propre est confiné entre deux portions de surfaces parallèles.

La figure 9B est une vue de dessus correspondant à la figure 9A. La zone en couronne repérée 46 correspond à la zone où l'écoulement de l'air ultra-propre est laminaire. Etant donné la variation d'épaisseur entre la surface à protéger 11 et l'élément soufflant, la vitesse de l'air ultra-propre est quasiment nulle au centre de l'élément soufflant, lorsqu'il sort du conduit 28. Au fur et à mesure que cette épaisseur diminue, la vitesse de l'écoulement est croissante, comme le symbolisent les vecteurs orientés radialement sur la figure 9B. Sur cette réalisation, l'élément soufflant doit avoir un diamètre plus important que le diamètre D de la surface à protéger 11, en l'occurrence un diamètre égal à 6D/5.

Dans ce cas, le débit de l'air et la distance d séparant les deux surfaces à leur périphérie contribuent également à former un rideau protecteur d'une efficacitée équivalente aux réalisations précédemment décrites.

On conçoit ainsi qu'il est possible de construire des rampes soufflantes adaptées à n'importe quel trajet d'objets possédant une surface plane horizontale à protéger de la contamination ambiante, l'adaptation de la forme de la rampe soufflante se faisant grâce aux différentes sortes d'éléments soufflants proposées, longitudinaux, ronds et d'extrémité.

**Revendications**

1. Rampe soufflante pour la protection de surfaces (1) d'objets (10) contre la contamination particulaire ambiante par confinement dans une atmosphère d'air ultrapropre au moyen d'éléments soufflants (25, 32, 33, 38) distribuant l'air ultrapropre par des orifices (6, 36) de distribution d'air débouchant par une surface soufflante (7) dans un espace où les objets à confiner (10) doivent être placés, caractérisée en ce qu'elle comprend plusieurs éléments soufflants assemblés les uns aux autres et composés chacun de :

- une plaque (2, 22) ayant une surface soufflante (7) comprenant au moins un orifice central ou médian (6, 26, 36) et ayant une forme complémentaire à celle d'au moins la périphérie des surfaces à protéger (11) ;
- une canalisation (4, 24, 34) fixée à la plaque (2, 22) débouchant dans l'orifice (6, 26, 36) et pouvant être reliée à une source d'air ultrapropre ; certains éléments soufflants (32, 33) étant allongés, leurs orifices étant constitués d'une rainure médiane longitudinale (36) ;

d'autres éléments soufflants (25) étant ronds et ayant un unique orifice central (26), constituant ainsi une rampe soufflante adaptable au trajet parcouru par les objets (10) portant la surface à protéger (11), les différents éléments soufflants étant mis bout à bout, la rampe étant ainsi adaptée pour confiner les surfaces à protéger (11) dans l'air ultrapropre en plaçant les surfaces à protéger (11) à une distance (d) relativement courte de la surface soufflante (7), l'air ultrapropre ayant un débit ayant une valeur comprise entre un débit minimal qui est le débit pour lequel l'air peut encore balayer toute les surfaces à protéger de l'objet (10) et sortir en périphérie de celles-ci, et un débit maximal qui est le débit juste au-dessus duquel apparaît un régime turbulent de l'air ultrapropre, l'écoulement de l'air ultrapropre dans le volume formé par les surfaces à protéger (11) et la surface soufflante (7) placées parallèlement en regard l'une de l'autre étant ainsi laminaire, au moins à la périphérie des surfaces à protéger.

**2.** Rampe soufflante selon la revendication 1, caractérisée en ce qu'elle comprend à chaque extrémité des éléments d'extrémité (38) comportant une portion transversale de canalisation formant ainsi un rideau d'air transversal.

**3.** Rampe soufflante selon l'une des revendications 1 ou 2, caractérisée en ce que chaque canalisation est complétée d'une chicane (9) placée en regard de conduits d'alimentation (8) débouchant dans les canalisations (4, 24, 34) améliorant ainsi la répartition de l'air ultrapropre dans toute la canalisation (4, 24, 34).

**Claims**

**1.** Blowing rail for the protection of surfaces (1) of objects (10) from ambient particulate contamination by confinement in an atmosphere of ultraclean air by means of blowing elements (25, 32, 33, 38) distributing the ultraclean air via air distribution orifices (6, 36) which emerge via a blowing surface (7) in a space where the objects (10) to be confined have to be placed, characterized in that it comprises several blowing elements joined together and each composed of:

- a plate (2, 22) having a blowing surface (7) which includes at least one central or median orifice (6, 26, 36) and has a shape complementary to that of at least the periphery of the surfaces (11) to be protected;
- a duct (4, 24, 34) fastened to the plate (2, 22) emerging in the orifice (6, 26, 36) and able to be connected to a source of ultraclean air; some of the blowing elements (32, 33) being elongate, their orifices consisting of a longitudinal median groove (36);

other blowing elements (25) being round and having a single central orifice (26), thus constituting a blowing rail which can be adapted to the path travelled by the objects (10) bearing the surface (11) to be protected, the various blowing elements being butted together, the rail thus being suitable for confining the surfaces (11) to be protected in the ultraclean air by placing the surfaces (11) to be protected at a relatively short distance (d) from the blowing surface (7), the ultraclean air having a flow rate whose value lies between a minimum flow rate, which is the flow rate for which the air can still sweep all the surfaces of the object (10) which are to be protected and leave at the periphery of these surfaces, and a maximum flow rate, which is the flow rate just above which a turbulent regime of the ultraclean air appears, the flow of the ultraclean air in the volume formed by the surfaces (11) to be protected and the blowing surface (7) which are placed parallel to each other thus being laminar, at least at the periphery of the surfaces to be protected.

**2.** Blowing rail according to Claim 1, characterized in that it includes, at each end, end elements (38) having a transverse duct portion thus forming a transverse air curtain.

**3.** Blowing rail according to either of Claims 1 and 2, characterized in that each duct is completed by a baffle (9) placed opposite the feed pipes (8) emerging in the ducts (4, 24, 34), thus improving the distribution of the ultraclean air throughout the duct (4, 24, 34).

**Patentansprüche**

**1.** Blasrampe zum Schutze der Oberflächen (1) von Gegenständen (10) gegen die Partikel-Verunreinigung aus der Umgebung durch Einschließung in eine Ultra-Reinluft-Atmosphäre mit Hilfe von Blaselementen (25, 32, 33, 38), die die Ultra-Reinluft durch Luftversorgungsöffnungen (6, 36) in einer Blasfläche (7) in einen Raum blasen, wo die einzuschließenden Gegenstände (10) angeordnet werden müssen,

**dadurch gekennzeichnet,** dass sie mehrere miteinander zusammengebaute Blaselemente umfasst, von denen jedes gebildet wird durch:

- eine Platte (2, 22) mit einer Blasfläche (7), die wenigstens eine zentrale oder mittlere Öffnung (6, 26, 36) umfasst und eine Form aufweist, die wenigstens zu der der Peripherie der zu schützenden Oberflächen (11) komplementär ist;
- einen Kanal (4, 24, 34), an der Platte (2, 22) befestigt und in der Öffnung (6, 26, 36) mündend, der mit einer Ultra-Reinluft-Quelle verbunden werden kann, wobei die Öffnungen bestimmter Blaselemente (32, 33), die länglich sind, durch einen Längs-Mittelschlitz (36) gebildet werden;

weitere Blaselemente (25), die rund sind und eine zentrale Öffnung (26) haben und so eine Blasrampe bilden, die an den Weg angepasst werden kann, den die Gegenstände (10) mit den zu schützenden Oberflächen (11) durchlaufen, wobei die verschiedenen Blaselemente aneinandergefügt sind und die Rampe angepasst ist, um die zu schützenden Oberflächen (11) in Ultra-Reinluft einzuschließen, indem die zu schützenden Oberflächen (11) mit einem relativ kleinen Abstand (d) von der Blasfläche (7) angeordnet werden, und die Ultra-Reinluft einen Durchsatz mit einem Wert hat, der enthalten ist zwischen einem Mindestdurchsatz, der ausreicht, damit die Luft noch alle zu schützenden Oberflächen des Gegenstands (10) bestreichen und an deren Peripherie austreten kann, und einem Höchstdurchsatz, der direkt bzw. knapp unter dem Durchsatz liegt, bei dem ein turbulenter Zustand der Ultra-Reinluft eintreten würde, sodass also die Strömung der Ultra-Reinluft in dem Volumen, das die zu schützenden Oberflächen (11) und die zu ihr parallele Blasfläche (7) bilden, laminar ist, wenigstens an der Peripherie der zu schützenden Oberflächen.

2. Blasrampe nach Anspruch 1, dadurch gekennzeichnet, dass sie an jedem Ende Endelemente (38) umfasst, gebildet durch ein quer angeordnetes Kanalstück, das einen quergerichteten Luftvorhang liefert.

3. Blasrampe nach einem der Ansprüche 1 oder 2, dadurch gekennzeichnet, dass jeder Kanal durch eine Schikane (9) vervollständigt wird, die den in die Kanäle (4, 24, 34) mündenden Versorgungsleitungen (8) gegenübersteht und für eine bessere Verteilung der Ultra-Reinluft im ganzen Kanal (4, 24, 34) sorgt.

FIG. 1

FIG. 2

FIG. 3

FIG. 4

FIG. 5

FIG. 6

FIG. 7

FIG. 8

FIG. 9 A

FIG. 9 B